# EUROPÄISCHE PATENTSCHRIFT

(11) **EP 2 286 496 B1**
(45) Veröffentlichungstag und Bekanntmachung des Hinweises auf die Patenterteilung: **01.08.2012**
(21) Anmeldenummer: 09757356.2
(22) Anmeldetag: 20.04.2009
(51) Int. Cl.: H02H 3/08, H02J 7/00, B60R 21/01, B60R 21/017, H02H 3/087

(54) **SCHUTZEINRICHTUNG GEGEN KORROSION FÜR EIN ELEKTRISCHES BORDNETZ UND VERFAHREN ZU DESSEN STEUERUNG**
PROTECTION DEVICE AGAINST CORROSION FOR AN ON-BOARD ELECTRICAL SYSTEM, AND METHOD FOR CONTROLLING SAID ON-BOARD ELECTRICAL SYSTEM
DISPOSITIF DE PROTECTION CONTRE LA CORROSION POUR UN RESEAU ELECTRIQUE DE BORD ET PROCEDE POUR SA COMMANDE

(30) Priorität: 02.06.2008 DE 102008002154
(43) Veröffentlichungstag der Anmeldung: 23.02.2011
(73) Patentinhaber: Robert Bosch GmbH, 70442 Stuttgart (DE)
(72) Erfinder: Leibfried, Oliver, 74936 Siegelsbach (DE); Gerstner, Roland, 72770 Reutlingen (DE)
(86) Internationale Anmeldenummer: PCT/EP2009/054664
(87) Internationale Veröffentlichungsnummer: WO 2009/146973

(56) Entgegenhaltungen:
- WO-A-02/080327
- WO-A-2005/115805
- DE-A1-102006 038 263
- US-A1- 2008 048 877
- US-B1- 6 646 845

## Beschreibung

### Stand der Technik

Die Erfindung betrifft ein Verfahren für die Steuerung eines elektrischen Bordnetzes nach dem Oberbegriff des Anspruchs 1. Weiterhin betrifft die Erfindung eine Schutzeinrichtung für die Durchführung des Verfahrens.

Das elektrische Bordnetz eines modernen Fahrzeugs mit einer Vielzahl elektrischer Verbraucher ist außerordentlich komplex. Bereits bei dem Entwurf eines derartigen Bordnetzes ist große Sorgfalt erforderlich, um über die Lebensdauer des Fahrzeugs eine hohe Betriebssicherheit zu garantieren. Trotz aller Sorgfalt bei dem Entwurf des Bordnetzes, kann nicht ausgeschlossen werden, dass während der Lebensdauer des Fahrzeugs Fehler in dem Bordnetz auftreten. Fehlerquellen sind beispielsweise eine unzulässige Beanspruchung von Komponenten des Bordnetzes und/oder eine mangelhafte Wartung des Fahrzeugs. Ein typischer Fehler ist ein Nebenschluss, der einen unkontrollierten Stromfluss zur Folge hat. Dieser kann, bei widrigen Umständen zu einem Schwelbrand und sogar zu einer Zerstörung des Fahrzeugs führen. Das Bordnetz eines modernen Fahrzeugs umfasst mindestens ein Steuergerät, das bei einem in Betrieb genommenen Fahrzeug auch derartige Fehler erkennen kann. Ein Problem kann allerdings bei einer längeren Betriebspause des Fahrzeugs auftreten, wenn das den Fehlertest durchführende Steuergerät abgeschaltet ist. Trotz Stillstand des Fahrzeugs sind aber immer noch zumindest Teile des Bordnetzes mit der Batterie verbunden. Ein Nebenschluss der immer noch unter Spannung stehenden Teile des Bordnetzes und eine durch den Nebenschluss verursachte thermische Korrosion können aber nun nicht mehr ohne weiteres erkannt werden.

Aus WO 2005/115805 A1 ist ein Batterieschutzschalter zur Trennung einer elektrischen Verbindung zwischen der Batterie eines Kraftfahrzeugs und einem Kraftfahrzeugbordnetz mit einem Halbleiterschalter zur Verbindung und Trennung der Batterie und des Kraftfahrzeugbordnetzes in Abhängigkeit von einem Überstrom und/oder einem Crash-Signal bekannt, bei dem der Halbleiterschalter für einen bidirektionalen Betrieb des Stroms ausgelegt ist, und der Halbleiterschalter leitend geschaltet wird, wenn die Spannung des Bordnetzes größer als die Batteriespannung ist. In der Stellung "Zündung AUS" des Kraftfahrzeug-Bordnetzes überwacht der Batterieschutzschalter auch die Ruhestromaufnahme des Bordnetzes. Durch Auswertung des gemessenen Ruhestroms kann ein unzulässig hoher Ruhestrom und damit ein Entleeren der Batterie rechtzeitig erkannt und verhindert werden. Zu diesem Zweck werden vorzugsweise die auch in der Stellung "Zündung AUS" an die Batterie angeschlossenen Verbraucher von der Batterie getrennt, wenn der Ruhestrom aus der Batterie einen vorgegebenen Grenzwert überschreitet.

WO 2005/115805 A1 ist als nächstliegender Stand der Technik zu sehen.

Aus DE 10 2006 038 263 Alist ein Kraftfahrzeugbordnetz bekannt, das mindestens eine Spannungsquelle umfasst, wobei ein Pol der elektrischen Spannungsquelle direkt oder über Schutzelemente mit elektrischen Verbrauchern verbunden ist und der andere Pol der elektrischen Spannungsquelle mit einem Rückleiter verbunden ist, der elektrisch zwischen den Verbrauchern und dem Pol der elektrischen Spannungsquelle angeordnet ist. Dabei ist der Rückleiter als mindestens eine Sammelschiene ausgebildet, die elektrisch von der Karosserie getrennt ist.

Aus US 2008/0048877 A1 ist ein Steuergerät für eine Stromversorgungseinrichtung bekannt, das ein in eine Versorgungsleitung zwischen der Stromquelle und einem Verbraucher geschaltetes Halbleiterschaltelement umfasst. Das Halbleiterschaltelement kann zum Zwecke der Stromversorgung des Verbrauchers zwischen EIN und AUS geschaltet werden. Eine kurzzeitige Abnormität des Halbleiterschaltelements wird festgestellt, wenn mindestens ein Spannungswert des Halbleiterschaltelements kleiner ist als ein erster Schwellwert und ein EIN-Zustand des Halbleiterschaltelements erfasst wird, wenn ein AUS-Signal zur Überleitung des Halbleiterschaltelements in den AUS-Zustand empfangen wird.

Aus US 6,646,845 B1 ist eine Batterieschutzschaltung bekannt, die eine zwischen dem positiven Pol und einem Verbraucher angeordnete Schalteinrichtung umfasst. Eine Steuereinrichtung steuert die Schalteinrichtung zwischen einer offenen und einer geschlossenen Stellung, wobei in der geschlossenen Stellung der Verbraucher mit der Batterie verbunden und in der offenen Stellung der Verbraucher von der Batterie getrennt ist. Die Batterieschutzschaltung umfasst eine Ladekontrollschaltung, die die Steuereinrichtung zur Öffnung der Schalteinrichtung veranlasst, wenn die Ladekontrollschaltung einen unterhalb einer vorgegebenen Schwelle liegenden Ladezustand erfasst. Die Batterieschutzschaltung umfasst auch eine Überwachungsschaltung, die die Steuereinrichtung zu einem Schließen der Schalteinrichtung veranlasst, wenn ein Startvorgang des Fahrzeugs erfasst wird.

### Offenbarung der Erfindung

Die Schutzeinrichtung umfasst einen Sensor für die Erfassung eines Nebenschlusses und eine von dem Sensor steuerbare Schalteinrichtung. Sobald der Sensor einen Nebenschluss erfasst, wird die Schalteinrichtung gesteuert, um ausgangsseitig einen Steuerimpuls bereitzustellen, der mindestens ein im Ruhezustand befindliches Steuergerät aktiviert. Das aktivierte Steuergerät überprüft das Bordnetz auf Fehler. Im Fehlerfall werden Schutzmaßnahmen eingeleitet, um das Fahrzeug in einen möglichst sicheren Zustand zu bringen. Um den Fehler zu dokumentieren und der Werkstatt das Auffinden des Fehlers zu erleichtern, wird vorteilhaft ein entsprechender Fehlercode in einer Speichereinrichtung eines Steuergeräts gespeichert. Bei einem in Betrieb befindlichen Fahrzeug wird vorteilhaft ein Warnsignal ausgegeben, um den Fahrer auf den Fehler aufmerksam zu machen. Bei Missachtung des Warnsignals können vorteilhaft Funktionen des Fahrzeugs abgeschaltet oder verändert werden, um den Fahrer nachhaltig zu einem Werkstattbesuch aufzufordern. Bei einem geparkten Fahrzeug aktiviert die Schutzeinrichtung nach Erkennung eines Fehlers zunächst ein im Ruhezustand befindliches Steuergerärt, das dann eine eingehende Uberprüfung des Bordnetzes durchführt. Bei einer Verifizierung des Fehlers werden weitere Steuergeräte aktiviert, die Hochstromverbraucher schalten, um die Batterie schnellstmöglich zu entladen. Eine entladene Batterie kann keine für eine thermische Korrosion förderliche Energie mehr zur Verfügung stellen. Durch die Erfindung wird das Fahrzeug zwar vorübergehend startunfähig. Es wird jedoch vorteilhaft in einen vor Korrosion sicheren Zustand versetzt. Auf diese Weise kann vorteilhaft ein großer Folgeschaden ausgeschlossen werden. Weitere Vorteile der Erfindung ergeben sich aus der folgenden Beschreibung, den Ansprüchen und der Zeichnung.

### Kurze Beschreibung der Zeichnungen

Die Erfindung wird nachfolgend anhand der Zeichnung beispielhaft näher erläutert. Dabei zeigt:
- Figur 1: ein erstes Ausführungsbeispiel der Erfindung;
- Figur 2: ein zweites Ausführungsbeispiel der Erfindung;
- Figur 3: ein drittes Ausführungsbeispiel der Erfindung mit einer Senseleitung;
- Figur 4: ein viertes Ausführungsbeispiel der Erfindung;
- Figur 5: ein Diagramm mit Darstellung von Eingangs- und Ausgangsspannung.

Thermische Korrosion wird in erster Linie durch einen nicht rechtzeitig erkannten Nebenschluss an dauerhaft an Batteriespannung liegenden Steckerpins bzw. Leitungen hervorgerufen. Hierbei handelt es sich um einen vergleichsweise langsamen Prozess, der von seinem Beginn bis zum Erreichen eines kritischen Zustands mehrere Tage dauern kann. Wird der Prozess nicht rechtzeitig erkannt, kann dies mindestens zur Zerstörung einzelner Komponenten des Bordnetzes führen, die ohne Reparatur einen Betrieb des Fahrzeugs nicht mehr zulässt. In besonders kritischen Fällen, kann durchaus auch ein Schwelbrand ausgelöst werden, der nicht nur das Bordnetz des Fahrzeugs gefährdet. Mit der Erfindung kann nun in vorteilhafter Weise ein wirksamer Schutz gegen die schädlichen Folgen eines Nebenschlusses und anschließender thermischer Korrosion erreicht werden.

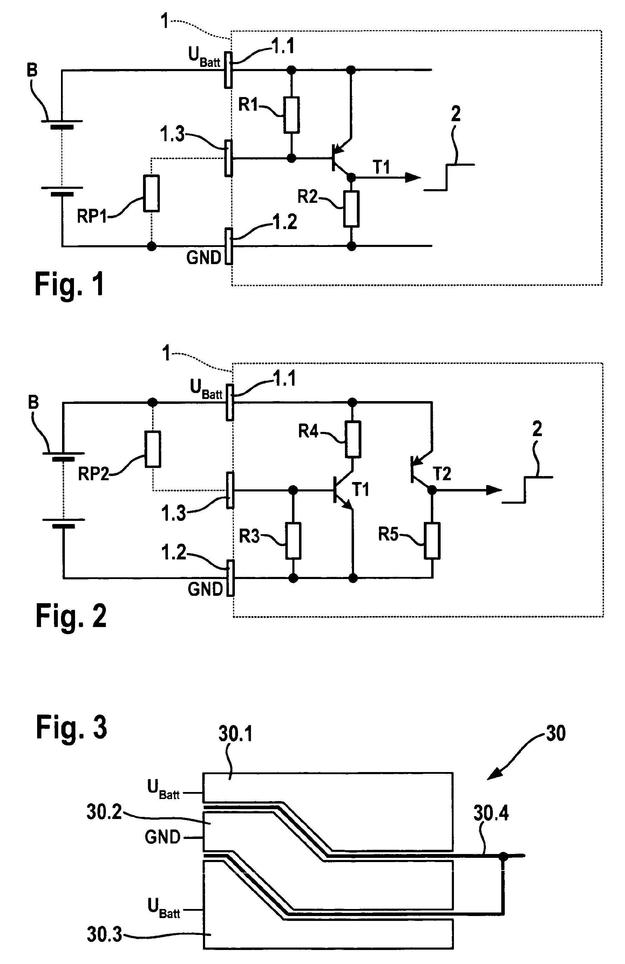

Figur 1 zeigt ein erstes Ausführungsbeispiel der Erfindung anhand eines Stromlaufplans eines Teilbereichs eines elektrischen Bordnetzes. Mit Bezugsziffer 1 ist ein Steuergerät bezeichnet, das während des Fahrzeugbetriebs auch Überwachungsfunktionen wahrnimmt, das jedoch bei Stillstand des Fahrzeugs abgeschaltet ist, um die Batterie B zu schonen. Auch im abgeschalteten Zustand ist das Steuergerät 1 jedoch über die Anschlüsse 1.1 und 1.2 dauerhaft mit der Batterie B verbunden. Ein in dem Steuergerät 1 auftretender Nebenschluss könnte daher zu thermischer Korrosion führen. Ein solches Nebenschluss nach Masse ist in Figur 1 durch den Widerstand RP1 angedeutet. Erfindungsgemäß ist nun eine Überwachungseinrichtung vorgesehen, die einen derartigen Nebenschluss rechtzeitig erfasst, so dass Gegenmaßnahmen eingeleitet werden können, bevor es zu größeren Schäden an dem Bordnetz und/oder dem Fahrzeug kommt. Die Überwachungseinrichtung umfasst einen Sensor 1.3, der eine aus einem Widerstand R1, einem Widerstand R2 und einem Transistor T1 bestehende Schalteinrichtung steuert. Sobald der in einem gefährdeten Bereich des Bordnetzes angeordnete Sensor 1.3 einen durch einen Fehlerstrom verursachten Spannungsabfall erfasst, wird die Schalteinrichtung gesteuert und erzeugt an ihrem Ausgangsanschluss einen Schaltimpuls 2, der das Steuergerät 1 aktiviert.

Das in Figur 2 dargestellte Ausführungsbeispiel geht von einem Nebenschluss zu dem positiven Pol der Batterie B aus, der an dem Anschluss 1.1 des Steuergeräts 1 liegt. Der durch den Nebenschluss fließende Strom erzeugt einen Spannungsabfall, der von dem Sensor 1.3 erfasst wird und eine aus dem Widerstand R3, einem Widerstand R4, einem Widerstand R5 und zwei Transistoren T1 und T2 bestehende Schalteinrichtung steuert. Sobald der in einem gefährdeten Bereich des Bordnetzes angeordnete Sensor 1.3 einen durch einen Fehlerstrom verursachten Spannungsabfall erfasst, wird die Schalteinrichtung gesteuert und erzeugt an ihrem Ausgangsanschluss einen Schaltimpuls 2, der das Steuergerät 1 aktiviert.

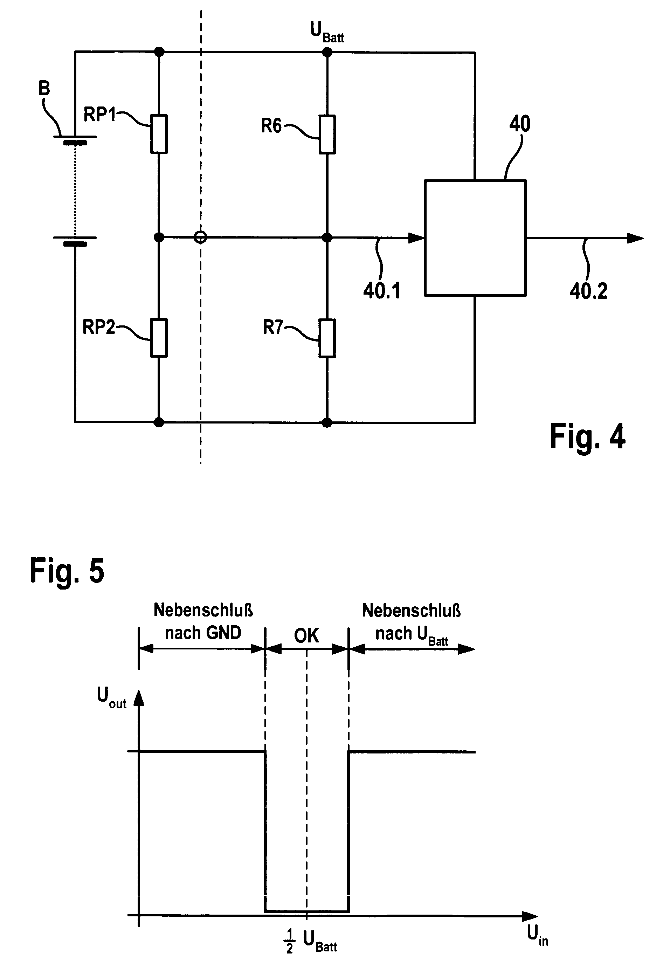

Eine in Figur 4 dargestellte vierte Ausführungsvariante umfasst eine Kombination der Ausführungsformen gemäß Figur 1 und Figur 2. Auf diese Weise können Nebenschlüsse nach Masse und/oder zu dem positiven Polder Batterie durch die gleiche Schaltungsanordnung erfasst werden. Diese Ausführungsvariante wird beispielsweise durch einen aus RP1 und RP2 bestehenden Spannungsteiler realisiert, der zwischen Plus und Masse liegt und dessen Mittenabgriff mit dem Eingang 40.1 eines Fensterkomparators 40 verbunden ist. Die jeweils an dem Ausgang 40.2 des Fensterkomparators 40 anstehende Spannung Uₒᵤₜ in Abhängigkeit von der an dem Eingang 40.1 anliegenden Eingangsspannung Uᵢₙ ist in dem in Figur 5 dargestellten Diagramm wiedergegeben. Bei Abwesenheit eines Nebenschlusses liegt an dem Eingang 40.1 und dem Ausgang 40.2 des Fensterkomparators 40 die Spannung ½ U_{Batt}, also die halbe Batteriespannung an. Bei einem Nebenschluss nach Masse (GND) oder bei einem Nebenschluss zu dem Pluspol (U_{Batt}) der Batterie B ist an dem Ausgang 40.2 des Fensterkomparators 40 dagegen eine wesentlich höhere Spannung messbar.

Im Folgenden werden Maßnahmen beschrieben, die ergriffen werden, wenn ein störender Nebenschluss erkannt wird. Da ein störender Nebenschluss auch während des Fahrbetriebs auftreten kann, wird beispielsweise durch ein Schaltsignal der durch ein Signal des Sensors 1.3 aktivierten Schalteinrichtung eine Warneinrichtung gesteuert, die den Fahrer auf diese Störung aufmerksam macht. Bei der Warneinrichtung kann es sich um eine Warneinrichtung handeln, die ein optisches, akustisches, haptisches Warnsignal oder eine beliebige Kombination dieser Signale ausgibt. Falls der Fahrer das Warnsignal missachtet, kann, im Rahmen einer weiteren Eskalationsstufe, eine wichtige Funktion des Steuergeräts 1 gezielt abgeschaltet werden, um den Fahrer zu einem Werkstattbesuch und zu einem vorsorglichen Tausch des Steuergeräts 1 zu motivieren. Auf diese Weise kann ein größerer Schaden als Folge einer thermischen Korrosion verhindert werden.

Besonders kritisch ist aber eine thermische Korrosion, die während einer längeren Stillstandsphase des Fahrzeugs unbemerkt abläuft. Ein längerer Stillstand des Fahrzeugs kommt beispielsweise vor, wenn das Fahrzeug, anlässlich einer Flugreise des Fahrers, längere Zeit in einem Parkhaus oder auf einem Parkplatz abgestellt ist. Sobald die Schutzeinrichtung des Bordnetzes einen kritischen Nebenschluss detektiert hat, wird die Schalteinrichtung gesteuert. Durch den an dem Ausgang der Schalteinrichtung erzeugten Steuerimpuls 2 wird ein Steuergerät des Fahrzeugs, beispielsweise das Steuergerät 1, in Betrieb genommen. Das aktivierte Steuergerät 1 überprüft das Bordnetz und seine Komponenten ggf. wiederholt. Wenn sich bei dieser Überprüfung herausstellt, dass es sich um einen Fehlalarm handelt, also kein kritischer Nebenschluss vorliegt, wird das Steuergerät 1, ggf. nach einer vorgebbaren Zeitverzögerung wieder abgeschaltet bzw. in den Ruhezustand versetzt. Wenn durch den Testlauf oder die Testläufe des Steuergeräts 1 jedoch ein kritischer Nebenschluss detektiert wird, bleibt das Steuergerät 1 eingeschaltet. Um das Auftreten des Fehlers dauerhaft zu dokumentieren, erfolgt zunächst ein entsprechender Eintrag in einen Fehlerspeicher des Steuergeräts. Dies erleichtert der Werkstatt die Eingrenzung des Fehlers bei einem späteren Auslesen des Fehlerspeichers. In einem nächsten Schritt werden weitere Steuergeräte alarmiert, die insbesondere Verbraucher des Bordnetzes mit hohem Stromverbrauch steuern. Diese Alarmierung kann bei einem mit einem Bussystem ausgestatteten Fahrzeug über das Bussystem erfolgen. Alternativ können die zusätzlichen Steuergeräte auch über spezielle Weckleitungen aktiviert werden. Die alarmierten Steuergeräte schalten in einen Betriebsmodus um, der einen besonders hohen Stromverbrauch zur Folge hat. Beispielsweise können die Zündung, die Heckscheibenheizung, die Sitzheizung, die Außenbeleuchtung des Fahrzeugs oder eine beliebige Kombination dieser Verbraucher, eingeschaltet werden. Der hohe Stromfluss durch diese Verbraucher führt zu einer raschen Entleerung der Batterie des Fahrzeugs. Diese steht nach Entleerung nicht mehr als Energiequelle zur Verfügung, so dass der thermischen Korrosion Einhalt geboten werden kann. Das auf diese Weise startunfähig gemachte Fahrzeug stellt eine wesentlich geringere Gefahr dar als ein Fahrzeug mit fortschreitender thermischer Korrosion.

Bei einem späteren Startversuch des geparkten Fahrzeugs wird zunächst die vollständig entleerte Batterie auffallen. Bei einem folgenden Start des Fahrzeugs nach Aufladen der leeren Batterie oder deren Tausch gegen eine geladene Batterie oder mit Starthilfe durch ein anderes Fahrzeug, erfolgt dann eine Fehleranzeige mit Warnung des Fahrers, da die Fehlerursache in dem Fehlerspeicher des Steuergeräts 1 gespeichert ist. Falls der Fahrer nach Neustart des Fahrzeugs diesen Fehlerhinweis missachtet, kann, wie bereits erwähnt, der Fahrer, durch Abschaltung oder Beschränkung wichtiger Betriebsfunktionen des Fahrzeugs, nachhaltig zu einem Werkstattbesuch veranlasst werden. Beispielsweise kann eine künstliche Drehzahlbegrenzung durch das Motorsteuergerät hervorgerufen werden. In der Werkstatt kann der Fehlerort anhand des Eintrags in dem Fehlerspeicher vergleichsweise einfach lokalisiert werden. Das den Nebenschluss verursachende Bauteil oder Steuergerät kann dann ausgetauscht werden. Damit die Funktionseinschränkung auch nach einem Fremdstart erhalten bleibt, wird die Fehlermeldung zweckmäßig in einem nichtflüchtigen Speicher, beispielsweise einem EEPROM, abgelegt.

Anstelle eines punktförmigen Sensors oder Kontaktpins kann, gemäß einem dritten Ausführungsbeispiel der Erfindung, auch eine Senseleitung vorgesehen sein, die einen ggf. auftretenden Nebenschluss erfasst. Dieses Ausführungsbeispiel wird durch Figur 3 erläutert, die eine Aufsicht auf eine vereinfacht dargestellte Leiterplatte 30 zeigt. Auf einer Oberfläche der Leiterplatte 30 sind mehrere Dauerspannung führende Leiterbahnen 30.1, 30.2, 30.3 aufgebracht. Die Leiterbahnen 30.1 und 30.3 sind beispielsweise mit dem Pluspol einer Batterie verbunden. Die Leiterbahn 30.2 ist mit dem Masseanschluss der Batterie verbunden. Zwischen den Leiterbahnen 30.1 und 30.2 bzw. 30.2 und 30.3 ist eine verzweigte Senseleitung 30.4 angeordnet. Diese Senseleitung 30.4 kann zwischen den Leiterbahnen 30.1, 30.2, 30.3 auftretende Nebenschlüsse sensieren und eine der beispielsweise in Figur 1 bzw. Figur 2 dargestellten Schalteinrichtungen steuern.

Der Sensor 1.3 kann zusätzlich auch so ausgebildet sein, dass er eine durch thermische Korrosion verursachte Temperaturerhöhung erfasst. Alternativ kann dafür auch ein zusätzlicher Temperatursensor vorgesehen sein.

## Patentansprüche

1. Verfahren für die Steuerung eines mindestens ein Steuergerät (1) umfassenden elektrischen Bordnetzes, das sich im Ruhezustand des Fahrzeugs in einem Ruhezustand befindet und bei dem Teile des Bordnetzes auch in dem Ruhezustand des Fahrzeugs mit der Batterie verbunden sind, wobei das Bordnetz eine von einem Fehlerströme erfassenden Sensor steuerbare Schalteinrichtung umfasst, die den Anschluss des Bordnetzes an die Batterie steuert, **dadurch gekennzeichnet, dass** bei Erfassung eines Fehlerstroms Hochstromverbraucher des Bordnetzes steuernde Steuergeräte aktiviert werden, um durch Stromfluss durch die Hochstromverbraucher die Batterie des Fahrzeugs zu entladen.

2. Verfahren nach Anspruch 1, **dadurch gekennzeichnet, dass** bei Erfassung eines Fehlerstroms die Zündung, die Heckscheibenheizung, die Sitzheizung, die Außenbeleuchtung des Fahrzeugs oder eine beliebige Kombination dieser Verbraucher eingeschaltet werden.

3. Verfahren nach Anspruch 1, **dadurch gekennzeichnet, dass** bei Detektion eines Nebenschlusses bzw. eines dadurch hervorgerufenen Fehlerstroms ein entsprechender Fehlercode in einer Speichereinrichtung eines Steuergeräts (1) gespeichert wird.

4. Verfahren nach einem der vorhergehenden Ansprüche, **dadurch gekennzeichnet, dass** bei Detektion eines Nebenschlusses, ein Warnsignal ausgegeben wird.

5. Verfahren nach einem der vorhergehenden Ansprüche, **dadurch gekennzeichnet, dass** bei Missachtung des Warnsignals eine Betriebsfunktion des Fahrzeugs verändert bzw. abgeschaltet wird, um den Fahrer zu einem Werkstattbesuch anzuhalten.

6. Verfahren nach einem der vorhergehenden Ansprüche, **dadurch gekennzeichnet, dass** die erreichbare Höchstgeschwindigkeit des Fahrzeugs begrenzt wird.

7. Verfahren nach einem der vorhergehenden Ansprüche, **dadurch gekennzeichnet, dass** durch das Motorsteuergerät eine Drehzahlbegrenzung hervorgerufen wird.

8. Schutzeinrichtung für die Durchführung des Verfahrens nach einem der vorhergehenden Ansprüche, **dadurch gekennzeichnet, dass** die Schutzeinrichtung Mittel für die Erfassung eines Nebenschlusses umfasst.

9. Schutzeinrichtung nach Anspruch 8, **dadurch gekennzeichnet, dass** als Mittel für die Erfassung eines Nebenschlusses eine zwischen den Leiterbahnen (30.1, 30.2, 30.3) angeordnete Senseleitung (30.4) vorgesehen ist.

10. Schutzeinrichtung nach Anspruch 8, **dadurch gekennzeichnet, dass** ein Temperatursensor vorgesehen ist, der auf eine durch einen Nebenschluss hervorgerufene erhöhte Temperatur reagiert.

## Claims

1. Method for controlling at least one on-board electrical system comprising a control device (1), said on-board electrical system being in a quiescent state in the quiescent state of the vehicle, and in which parts of the on-board system are also connected to the battery in the quiescent state of the vehicle, wherein the on-board system comprises a switching device which can be controlled by a sensor which senses fault currents and which controls the connection of the on-board system to the battery, **characterized in that**, when a fault current is sensed, control devices which control high-current loads of the on-board system are activated in order to discharge the battery of the vehicle through a flow of current through the high-current loads.

2. Method according to Claim 1, **characterized in that**, when a fault current is sensed, the ignition, the rear windscreen heater, the seat heater, the exterior lighting of the vehicle or any desired combination of these loads are switched on.

3. Method according to Claim 1, **characterized in that**, when a shunt is detected, or a fault current caused as a result of shunt is detected, a corresponding fault code is stored in a storage device of a control device (1).

4. Method according to one of the preceding claims, **characterized in that**, when a shunt is detected, a warning signal is output.

5. Method according to one of the preceding claims, **characterized in that**, when the warning signal is disregarded, an operating function of the vehicle is changed or switched off in order to oblige the driver to visit a workshop.

6. Method according to one of the preceding claims, **characterized in that** the maximum speed of the vehicle which can be reached is limited.

7. Method according to one of the preceding claims, **characterized in that** the engine control device brings about limitation of rotational speed.

8. Protection device of carrying out the method according to one of the preceding claims, **characterized in that** the protection device comprises means for sensing a shunt.

9. Protection device according to Claim 8, **characterized in that** a sensing line (30.4) which is arranged between the conductor tracks (30.1, 30.2, 30.3) is provided as means for sensing a shut.

10. Protection device according to Claim 8, **characterized in that** a temperature sensor is provided which reacts to a raised temperature caused by a shunt.

## Revendications

1. Procédé pour la commande d'un réseau électrique de bord comprenant au moins un appareil de commande (1), ledit réseau se trouvant dans un état de repos lorsque le véhicule est à l'état de repos et des parties du réseau de bord étant également reliées à la batterie dans l'état de repos du véhicule, le réseau de bord comprenant un dispositif de connexion pouvant être commandé par un capteur détectant des courants de fuite, ledit dispositif commandant le raccordement du réseau de bord à la batterie, **caractérisé en ce qu'**en cas de détection d'un courant de fuite, des appareils de commande commandent un élément récepteur à forte consommation de courant du réseau de bord pour décharger la batterie du véhicule grâce au courant traversant l'élément récepteur à forte consommation de courant.

2. Procédé selon la revendication 1, **caractérisé en ce que** lorsqu'un courant de fuite est détecté, l'allumage, le chauffage de lunette arrière, le chauffage de siège, l'éclairage extérieur du véhicule ou une combinaison quelconque de ces éléments consommateurs de courant sont connectés.

3. Procédé selon la revendication 1, **caractérisé en ce que** lorsqu'un court-circuit et/ou un courant de fuite provoqué par lui est détecté, un code d'anomalie correspondant est mémorisé dans un dispositif de mémoire d'un appareil de commande (1).

4. Procédé selon l'une quelconque des revendications précédentes, **caractérisé en ce qu'**un signal d'avertissement est émis lorsqu'un court-circuit est détecté.

5. Procédé selon l'une quelconque des revendications précédentes, **caractérisé en ce que** lorsque le signal d'avertissement n'est pas pris en compte, une fonction d'état de service du véhicule peut être modifiée et/ou déconnectée pour obliger le conducteur à effectuer une visite de contrôle dans un atelier.

6. Procédé selon l'une quelconque des revendications précédentes, **caractérisé en ce que** la vitesse du véhicule maximale pouvant être atteinte est plafonnée.

7. Procédé selon l'une quelconque des revendications précédentes, **caractérisé en ce que** le plafonnement du nombre de tours est demandé par l'appareil de commande du moteur.

8. Dispositif de protection permettant de mettre en oeuvre le procédé selon l'une quelconque des revendications précédentes, **caractérisé en ce que** le dispositif de protection comprend des moyens de détection d'un court-circuit.

9. Dispositif de protection selon la revendication 8, **caractérisé en ce que** le moyen de détection de court-circuit prévu est un câble de détection (30.4) disposé entre les pistes conductrices (30.1, 30.2, 30.3).

10. Dispositif de protection selon la revendication 8, **caractérisé en ce qu'**un capteur de température réagissant à une augmentation de température provoquée par un court-circuit est prévu.
